(19) Europäisches Patentamt
European Patent Office
Office européen des brevets

(11) **EP 3 451 389 B1**

(12) **FASCICULE DE BREVET EUROPEEN**

(45) Date de publication et mention
de la délivrance du brevet:
**01.07.2020 Bulletin 2020/27**

(51) Int Cl.:
*H01L 31/0232* *(2014.01)*      *G02B 6/42* *(2006.01)*
*H01L 31/107* *(2006.01)*

(21) Numéro de dépôt: **18187629.3**

(22) Date de dépôt: **07.08.2018**

(54) **PHOTODIODE À AVALANCHE**

AVALANCHE-FOTODIODE

AVALANCHE PHOTODIODE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **25.08.2017 FR 1757874**

(43) Date de publication de la demande:
**06.03.2019 Bulletin 2019/10**

(73) Titulaire: **Commissariat à l'Energie Atomique et
aux Energies
Alternatives
75015 Paris (FR)**

(72) Inventeurs:
• **HASSAN, Karim**
  **89470 MONETEAU (FR)**
• **BOUTAMI, Salim**
  **38100 GRENOBLE (FR)**

(74) Mandataire: **Hautier, Nicolas
Cabinet Hautier
20, rue de la Liberté
06000 Nice (FR)**

(56) Documents cités:
**US-A1- 2015 076 641     US-A1- 2015 108 327**

**Description**

DOMAINE TECHNIQUE DE L'INVENTION

L'invention concerne le domaine de la photonique et de l'optoélectronique. Elle trouve pour application particulièrement avantageuse le domaine des photodiodes à avalanche et plus précisément le domaine des photodiodes à avalanche de type SAM et/ou SACM (signifiant « régions d'absorption et de multiplication séparées » et « régions d'absorption, de multiplication et de charge séparées » respectivement), fonctionnant par exemple dans le spectre proche infrarouge.

ÉTAT DE LA TECHNIQUE

Dans le domaine de la détection proche infrarouge (IR) en photonique sur silicium, une photodiode peut généralement comprendre une partie en silicium et une partie en germanium. La partie en silicium, transparente dans le proche infrarouge, peut servir à guider des photons proche IR jusque dans la partie en germanium. Cette partie en germanium sert généralement à détecter par absorption les photons proche IR.

Un principe de cette détection est le suivant : un photon est absorbé dans le germanium. L'absorption de ce photon génère une paire électron-trou. L'électron et le trou peuvent être ensuite collectés via des électrodes. Le courant électrique généré par cet électron et ce trou, appelés porteurs de charges, peut ainsi être exploité pour la détection du photon à l'origine du phénomène.

Pour augmenter la sensibilité d'une telle détection, l'électron peut être soumis à un champ électrique important de manière à être fortement accéléré et à ioniser par impact les atomes environnants. Ces atomes ionisés vont à leur tour générer des électrons qui vont également ioniser d'autres atomes, produisant ainsi un phénomène de multiplication des électrons par ionisation, appelé phénomène d'avalanche.

Une photodiode à avalanche est avantageusement basée sur ce principe de multiplication de manière à augmenter la sensibilité de détection, et peut ainsi détecter des flux lumineux de très faible intensité.

Idéalement, le phénomène de multiplication a lieu dans une partie en silicium de la photodiode à avalanche, générant très peu de bruit de multiplication.

La photodiode à avalanche (APD pour l'acronyme anglais « avalanche photodiode ») comprend une zone d'absorption, de préférence en germanium, séparée d'une zone de multiplication, de préférence en silicium. Cette configuration est dite SAM (pour l'acronyme anglais « Separate Absorption and Multiplication régions »).

En pratique cependant, le phénomène de multiplication se produit également de manière involontaire en partie dans le germanium. Dans ce cas, un bruit de multiplication important est généré et limite significativement les performances de photodétection de la photodiode à avalanche.

Afin de réduire ce bruit de multiplication dans le germanium, une possibilité peut être l'ajout d'une zone ou d'une couche dite zone de charge entre la zone d'absorption et la zone de multiplication, de façon à réduire le champ électrique dans le germanium tout en maintenant un champ électrique exploitable dans le silicium. La part de porteurs multipliés dans le germanium est ainsi réduite. Le bruit de multiplication dans le germanium, appelé également facteur d'excès de bruit, diminue en conséquence. Cette configuration est dite SACM (pour l'acronyme anglais « Separate Absorption, Charge and Multiplication régions »).

Les documents US2015/0108327 et US2015/0076641 décrivent des photodiodes à avalanche avec un guide d'onde formant un circuit fermé courbe.

Le document « Développement de photodiodes à avalanche en Ge sur Si pour la détection faible signal et grande vitesse, Léopold VIROT, thèse de doctorat, Université Paris Sud-Paris XI, 2014 » divulgue une telle photodiode à avalanche en configuration SACM.

En pratique, avec les photodiodes à avalanche décrites dans ce document, même en configuration SACM, la multiplication des porteurs dans le germanium reste importante.

Pour réduire le facteur d'excès de bruit, une solution consiste à réduire le volume de germanium. Cette réduction de volume se fait cependant au détriment de l'absorption. Cette photodiode présente alors des capacités d'absorption réduites et un seuil de saturation plus bas. Cette solution conduit donc à des photodiodes présentant une gamme de détection en intensité restreinte.

Dans le cas d'une collecte latérale des porteurs de charge, c'est-à-dire selon une direction parallèle à une largeur du cœur en germanium, une autre solution consiste à réduire la largeur du cœur en germanium en augmentant la longueur dudit cœur à volume de germanium constant. L'augmentation en longueur entraîne cependant une détérioration de la compacité et de la bande passante de la photodiode.

Un objet de la présente invention est de pallier les inconvénients cités plus ci-dessus.

En particulier, un objet de la présente invention est de proposer une photodiode à avalanche présentant une compacité et/ou une bande passante améliorées tout en limitant le facteur d'excès de bruit.

Les autres objets, caractéristiques et avantages de la présente invention apparaîtront à l'examen de la description suivante et des dessins d'accompagnement. Il est entendu que d'autres avantages peuvent être incorporés.

RÉSUMÉ DE L'INVENTION

Pour atteindre cet objectif, un premier aspect de l'invention concerne une photodiode à avalanche telle que définie par l'objet de la revendication 1 comprenant une zone d'absorption, une zone de multiplication, une première électrode et une deuxième électrode.

De façon avantageuse, la photodiode comprend en outre un guide d'onde formant un circuit fermé apte à guider un flux lumineux sur plusieurs tours dudit circuit.

La zone d'absorption s'étend sur au moins une portion dudit circuit fermé courbe. La zone de multiplication, les première et deuxième électrodes s'étendent le long d'une partie au moins dudit circuit fermé courbe.

Le flux lumineux peut ainsi se propager au sein du guide d'onde sur plusieurs tours du circuit fermé. Dès lors, les capacités d'absorption de la zone d'absorption de la photodiode sont préservées tandis que le volume de ladite zone d'absorption, de préférence le volume de germanium formant la zone d'absorption, est réduit.

La compacité de la photodiode est avantageusement améliorée.

En outre, les première et deuxième électrodes présentent une dimension en longueur inférieure à ou sensiblement égale à un périmètre du circuit fermé courbe. Cette dimension en longueur, en particulier la dimension en longueur de l'électrode collectant les électrons, impacte proportionnellement une capacité de la photodiode, ladite capacité étant inversement proportionnelle à la bande passante de la photodiode.

Dès lors, il est particulièrement avantageux de diminuer ou limiter la longueur d'électrode de manière à augmenter la bande passante de la photodiode.

En particulier, pour une longueur d'électrode fixée, la capacité de la photodiode et donc la bande passante de la photodiode restent avantageusement constantes quel que soit le nombre de tours parcourus par le flux lumineux au sein du guide d'onde.

La distance parcourue par le flux lumineux au sein de la zone d'absorption, en particulier la distance nécessaire à l'absorption complète dudit flux lumineux, peut donc être supérieure à la longueur d'électrode nécessaire à la collecte des électrons générés lors de ladite absorption, notamment lorsque le flux lumineux parcoure au moins un tour au sein du guide d'onde.

Dans ce cas, la photodiode selon l'invention permet avantageusement d'absorber et de détecter la totalité du flux lumineux sans détériorer la bande passante de ladite photodiode.

La photodiode selon l'invention présente donc avantageusement une compacité et une bande passante simultanément améliorées, tout particulièrement lorsque le flux lumineux est amené à parcourir au moins un tour au sein du guide d'onde.

Des caractéristiques avantageuses mais uniquement optionnelles de la photodiode selon l'invention vont maintenant être énoncées ci-dessous.

De préférence, pour qu'un flux lumineux puisse parcourir au moins un tour du guide d'onde, ce dernier peut avantageusement présenter un petit rayon de courbure, par exemple compris entre $5\mu m$ et $20\mu m$.

Selon une possibilité, la collecte des électrons peut se faire par une électrode positionnée latéralement vis-à-vis des zones d'absorption et de multiplication. La zone d'absorption, la zone de multiplication et l'électrode de collecte peuvent avantageusement s'étendre de manière concentrique sur un plan de base.

Les électrons générés dans la zone d'absorption sont alors accélérés selon une direction parallèle au plan de base et orthogonale à une direction de propagation du flux lumineux, dans une largeur de la zone d'absorption, avant d'être multipliés dans la zone de multiplication et collectés par l'électrode de collecte.

Dans ce cas, il est particulièrement avantageux de limiter la largeur de la zone d'absorption de manière à réduire le facteur d'excès de bruit de multiplication dans cette zone d'absorption.

Selon un mode de réalisation, la largeur de la zone d'absorption peut avantageusement être inférieure à 200nm, de préférence inférieure à 100nm. Dans le germanium par exemple, le phénomène de multiplication par ionisation devient négligeable pour une largeur de germanium inférieure à 100nm.

Pour compenser cette réduction de largeur de la zone d'absorption, la photodiode peut être configurée pour guider la propagation du flux lumineux sur une distance plus grande au sein de la zone d'absorption.

La propagation du flux lumineux est guidée par le guide d'onde.

De préférence, le guide d'onde comprend un cœur et une gaine de manière à confiner géométriquement le flux lumineux au niveau du cœur du guide d'onde.

Le guide d'onde peut être en silicium intrinsèque de façon à limiter les pertes optiques lors du guidage du flux lumineux. Le cœur et la gaine sont dès lors au moins en partie en silicium intrinsèque.

Pour un guide d'onde par contraste d'indice entre le cœur et la gaine, la largeur de la zone d'absorption peut être sensiblement égale à la largeur du cœur du guide d'onde. Dans ce cas, le cœur peut être en germanium et la gaine peut être au moins en partie en silicium intrinsèque.

Pour une largeur de zone d'absorption réduite cependant, un tel guide d'onde par contraste d'indice ne guide plus la propagation du flux lumineux efficacement.

Selon une possibilité préférée et particulièrement avantageuse, le guide d'onde peut dès lors être un guide de type guide en arête. Un tel guide en arête permet de confiner le flux lumineux de manière géométrique.

Pour une largeur de zone d'absorption réduite, la propagation du flux lumineux peut donc être avantageusement guidée de manière efficace par un guide en arête.

La photodiode selon l'invention peut ainsi permettre de réduire le facteur d'excès de bruit dans la zone d'absorption tout en présentant une compacité et une bande passante améliorées.

A contrario, les solutions de l'art antérieur enseignées par le document « Développement de photodiodes à avalanche en Ge sur Si pour la détection faible signal et grande vitesse » thèse de Léopold VIROT mentionné ci-dessus, suggèrent d'augmenter linéairement la longueur de la zone d'absorption et de l'électrode de collecte de la photodiode, au détriment de la compacité et de la bande passante de ladite photodiode.

Un deuxième aspect de la présente invention concerne un procédé de fabrication d'une photodiode à avalanche selon le premier aspect de l'invention.

Le procédé de fabrication comprend notamment les étapes suivantes :

- Fournir un substrat de type silicium sur isolant (SOI) comprenant une couche supérieure en silicium (Si),
- Lithographie de manière à définir des limites de la zone d'absorption dans un plan xy,
- Gravure selon un axe z d'une partie seulement de l'épaisseur de la couche supérieure de manière à former une cavité délimitée par les limites de la zone d'absorption définies par lithographie,
- Dépôt de germanium (Ge), de préférence par épitaxie, dans ladite cavité de manière à former la zone d'absorption,
- Lithographie de manière à définir des limites du guide d'onde selon un circuit fermé courbe comprenant la zone d'absorption,
- Gravure selon un axe z d'une partie de l'épaisseur du silicium entourant lesdites limites du guide d'onde, de manière à former au moins une partie du guide d'onde, de préférence de manière à former au moins une partie d'un guide de type guide en arête,
- Formation des électrodes au niveau de zones de contact situées de part et d'autre du guide d'onde.

La photodiode selon l'invention pourra avantageusement équiper un photodétecteur infrarouge dans le domaine de la photonique sur silicium.

BRÈVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :

- La FIGURE 1 est une vue en perspective d'une coupe d'un guide en anneau selon un mode de réalisation non limitatif de la présente invention ;
- La FIGURE 2a illustre une simulation des pertes optiques au sein d'un guide en anneau selon un mode de réalisation de la présente invention ;
- La FIGURE 2b illustre une simulation des pertes optiques au sein d'un guide en anneau selon un autre mode de réalisation de la présente invention ;
- La FIGURE 3a est une vue de dessus d'une photodiode selon un mode de réalisation de la présente invention dans lequel la zone d'absorption forme un circuit fermé ;
- La FIGURE 3b est une vue de dessus d'une photodiode selon un autre mode de réalisation de la présente invention dans lequel la zone d'absorption forme une courbe ouverte ;
- La FIGURE 4 est une vue de dessus d'une photodiode selon un autre mode de réalisation de la présente invention, illustrant une forme particulière d'électrodes ;
- La FIGURE 5 est une vue de dessus d'une photodiode selon un autre mode de réalisation de la présente invention dans lequel la zone d'absorption et le guide d'onde forment des courbes non circulaires ;
- La FIGURE 6a illustre des étapes d'un procédé de fabrication d'une photodiode selon un mode de réalisation de la présente invention ;
- La FIGURE 6b illustre des étapes d'un procédé de fabrication d'une photodiode selon un autre mode de réalisation de la présente invention ;

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs et dimensions des différentes couches et portions des photodiodes illustrées ne sont pas représentatives de la réalité.

DESCRIPTION DÉTAILLÉE DE L'INVENTION

L'invention selon son premier aspect comprend notamment les caractéristiques optionnelles ci-après pouvant être utilisées en association ou alternativement :

-    Selon un exemple, la zone d'absorption, la zone de multiplication, la première électrode et la deuxième électrode s'étendent respectivement :

    ◦ selon un profil courbe d'un circuit a, également désigné portion courbe d'un circuit a,
    ◦ un profil courbe d'un circuit b, également désigné portion courbe d'un circuit m,
    ◦ un profil courbe d'un circuit e1, également désigné portion courbe d'un circuit e1 et
    ◦ un profil courbe d'un circuit e2, également désigné portion courbe e2 d'un circuit,

    lesdites profils courbes desdits circuits a, m, e1 et e2 étant parallèles entre eux sur une partie au moins de leurs longueurs respectives et parallèles audit plan de base xy.
-    Selon un exemple, lesdites portions le long desquelles la zone de multiplication, les première et deuxième électrodes s'étendent, correspondent en partie au moins à ladite portion le long de laquelle ladite zone d'absorption s'étend.
-    Selon un exemple, lesdites portions le long desquelles la zone de multiplication, les première et deuxième électrodes s'étendent, sont situées au moins partiellement en regard de ladite portion le long de laquelle ladite zone d'absorption s'étend.
-    Selon un exemple, la zone d'absorption forme au moins une portion d'un premier circuit ovale et la zone de multiplication forme au moins une portion d'un deuxième circuit ovale, de sorte que lesdits premier et deuxième circuits ovales soient concentriques ou plus généralement aient leurs barycentres confondus.
-    Selon un exemple, le guide est courbe. Il est refermé sur lui-même.
-    Selon un exemple, le guide présente une symétrie autour d'un axe. Selon un autre exemple, le guide ne présente pas de symétrie particulière.
-    Selon un exemple, les premier et deuxième circuits ovales sont pris parmi : des circuits elliptiques, des circuits de formes oblongues.
-    Selon un exemple, les premier et deuxième circuits ovales sont des circuits circulaires.
-    Selon un exemple, les circuits circulaires présentent un rayon de courbure compris entre $5\mu m$ et $20\mu m$.
    Une telle gamme de rayons de courbure permet avantageusement de favoriser une propagation du flux lumineux sur plusieurs tours du guide d'onde tout en limitant les pertes radiatives par courbure. Cette gamme permet en outre une bonne compacité de la photodiode.
-    Selon un exemple, le guide d'onde comprend un cœur et une gaine et la zone d'absorption est située au moins en partie au niveau dudit cœur.
    Cette disposition optimise un recouvrement entre la zone d'absorption et le flux lumineux, ledit flux lumineux étant confiné au niveau du cœur.
-    Selon un exemple, le cœur comprend un matériau de guidage, de préférence du silicium, différent d'un matériau de la zone d'absorption. Le matériau de guidage enveloppe entièrement la zone d'absorption.
-    Selon un exemple, la zone d'absorption présente une hauteur h sensiblement égale à une hauteur h' de la zone de multiplication.
-    Selon un exemple, la zone d'absorption est contenue dans un premier ensemble de plans et la zone de multiplication est contenue dans un deuxième ensemble de plans. Les plans des premier et deuxième ensembles sont parallèles au plan de base xy. Certains au moins des plans des premier et deuxième ensembles sont identiques. Ainsi, sur une portion au moins de leur hauteur h et h", prise selon une direction z perpendiculaire au plan de base xy, la zone d'absorption et la zone de multiplication sont contenues dans des plans coplanaires.
-    En projection dans chacune des plans qui sont parallèles au plan de base xy et qui passent à la fois par la couche d'absorption et par la couche de multiplication, la couche d'absorption et par la couche de multiplication sont concentriques.
-    En projection dans chacune des plans qui sont parallèles au plan de base xy et qui passent à la fois par la couche d'absorption et par la zone de charge, la couche d'absorption et par la zone de charge sont concentriques.
-    Selon un exemple, la zone d'absorption 2 et la zone de multiplication 3, s'étendent respectivement selon une portion courbe d'un circuit a et une portion courbe d'un circuit m, et en projection sur le plan de base (xy) :

○ lesdites portions courbes desdits circuits a, m, sont parallèles entre elles sur une partie au moins de leurs longueurs respectives, et
○ la portion courbe du circuit a est située à l'intérieur de la portion courbe du circuit m.

La première électrode 4 et la deuxième électrode 5 s'étendent respectivement selon une portion courbe d'un circuit e1 et une portion courbe d'un circuit e2. En projection sur le plan de base (xy) :

○ la portion courbe du circuit e1 de la première électrode est située à l'intérieur, de préférence entièrement à l'intérieur, de la portion courbe du circuit a de la zone d'absorption,
○ la portion courbe du circuit a de la zone d'absorption est située à l'intérieur, de préférence entièrement à l'intérieur, de la portion courbe du circuit m de la zone de multiplication,
○ la portion courbe du circuit m de la zone de multiplication est située à l'intérieur, de préférence entièrement à l'intérieur, de la portion courbe du circuit e2 de la deuxième électrode.

- Selon un exemple, en projection sur le plan de base (xy) la zone de multiplication et la première électrode sont situées de part et d'autre de la zone d'absorption.
- La zone de multiplication n'est pas située à l'aplomb, c'est-à-dire au-dessus ou au-dessous, de la zone d'absorption selon une direction z perpendiculaire au plan de base xy.
- Selon un exemple, en projection sur le plan de base (xy) la zone d'absorption est située à distance de la zone de multiplication.
- Selon un exemple, en projection sur le plan de base (xy) la zone de charge et la première électrode sont situées de part et d'autre de la zone d'absorption.
- Selon un exemple, la zone de charge n'est pas située à l'aplomb, c'est-à-dire au-dessus ou au-dessous, de la zone d'absorption selon une direction z perpendiculaire au plan de base xy.
- Selon un exemple, en projection sur le plan de base (xy) la zone d'absorption est située à distance de la zone de charge.
- Selon un exemple, selon une coupe perpendiculaire au plan de base xy et passant par la perpendiculaire à la tangente au circuit c fermé courbe, la zone d'absorption est en regard, de préférence entièrement en regard, de la zone de multiplication.
- Selon un exemple, selon une coupe perpendiculaire au plan de base xy et passant par la perpendiculaire à la tangente au circuit c fermé courbe, la zone d'absorption est en regard, de préférence entièrement en regard, de la zone de charge.
- Selon un exemple, la zone d'absorption et la zone de multiplication sont contenues, au moins en partie, entre des plans identiques et parallèles au plan de base xy.
- Selon un exemple, la zone d'absorption et la zone de charge sont contenues, au moins en partie, entre des plans identiques et parallèles au plan de base xy.
- Selon un exemple, la zone d'absorption est en regard de la zone de multiplication selon un plan parallèle au plan de base xy.
- Selon un exemple, la zone d'absorption est en regard de la zone de charge selon un plan parallèle au plan de base xy.
- Selon un exemple, la zone d'absorption et la zone de multiplication sont en regard l'une de l'autre selon une direction parallèle au plan de base xy et perpendiculaire à la tangente au circuit c fermé courbe. La zone d'absorption et la zone de multiplication s'étendent principalement selon des portions courbes parallèles entre elles et parallèles audit plan de base xy et les hauteurs h et h'', sont mesurées selon une direction qui est perpendiculaire audit plan de base xy. Ce mode de réalisation permet de faciliter l'extraction horizontale des charges électriques, parallèlement au plan de base xy, par le champ électrique appliqué.
- Selon un exemple, la zone de multiplication est entièrement comprise dans le ruban (slab).
- Selon un exemple, la zone de charge est entièrement comprise dans le ruban (slab).
- Selon un exemple, la photodiode comprend lesdites deux électrodes uniquement. Elle ne comprend pas une troisième électrode ce qui générerait des pertes.
- Selon un exemple, la zone d'absorption forme un circuit courbe fermé, et la première électrode et la zone de multiplication sont situées de part et d'autre du circuit courbe fermé formé par la zone d'absorption.
- Selon un exemple, le cœur comprend un matériau de guidage, de préférence du silicium, différent d'un matériau de la zone d'absorption. Le matériau de guidage enveloppe une partie seulement de la zone d'absorption, et la gaine enveloppe une partie complémentaire de la zone d'absorption.
- Selon un exemple, le guide d'onde est un guide de type guide en arête (RIB). Le confinement du flux lumineux peut ainsi être purement géométrique, il n'est donc pas nécessaire de configurer la zone d'absorption de manière à confiner le flux lumineux.

- Selon un exemple, la zone d'absorption forme un circuit courbe fermé, et la première et la deuxième électrode sont situées de part et d'autre de la zone d'absorption. De préférence, la deuxième électrode entoure entièrement ledit circuit courbe fermé formé par la zone d'absorption.

Ce mode de réalisation permet d'absorber un maximum de flux lumineux au niveau de la zone d'absorption à chaque tour parcouru par le flux lumineux au sein du guide d'onde.

- Selon un exemple, la zone d'absorption forme un circuit courbe ouvert de sorte que le guide d'onde présente une portion exempte de zone d'absorption, et la première et la deuxième électrode ne sont pas situées de part et d'autre de ladite portion du guide d'onde exempte de zone d'absorption.

Ce mode de réalisation permet d'éviter de générer inutilement des charges au niveau d'une portion du guide d'onde non bordée par une électrode, la collecte des charges au niveau de cette portion étant en effet faible ou nulle. L'efficacité de détection de la photodiode peut ainsi être améliorée.

En outre, le flux lumineux n'étant pas absorbé sur cette portion, il peut parcourir une distance ou un nombre de tours plus important au sein de la photodiode. La bande passante de la photodiode peut ainsi être améliorée.

- Selon un exemple, la zone d'absorption présente une largeur $L < 200nm$, de préférence $L < 100nm$, la zone d'absorption s'étendant parallèlement au plan de base xy, c'est-à-dire que la zone d'absorption s'étend principalement, et de préférence entièrement, dans des plans parallèles au plan de base xy. La largeur L, en un point donné, étant mesurée selon une direction qui est parallèle audit plan de base xy et qui est perpendiculaire à une tangente, en ce point donné, à la zone d'absorption.

Une zone d'absorption présentant une telle largeur L permet de minimiser le facteur d'excès de bruit. Ce mode de réalisation permet d'obtenir une photodiode à largeur de zone d'absorption fine, de préférence à largeur de Ge fine.

- Selon un exemple, la zone d'absorption s'étend principalement, et de préférence entièrement, dans des plans parallèles au plan de base xy.

  ○ Selon un exemple, la zone d'absorption forme un premier circuit courbe présentant une longueur $l_1$ et la zone de multiplication forme un deuxième circuit courbe bordant le premier circuit courbe et présentant une longueur $l_2$. Selon un exemple, $l_2 \geq l_1$, les longueurs $l_1$ et $l_2$ étant mesurées dans ledit plan de base xy. Selon un autre exemple $l_2 < l_1$.

  ○ Selon un exemple, la zone d'absorption forme un premier circuit courbe présentant une longueur $l_1$, et le circuit c fermé courbe présente une longueur $l_c$, les longueurs $l_1$ et $l_c$ étant mesurées dans ledit plan de base xy, tel que :
  $$\gamma_1 \cdot l_c \leq l_1 \leq \gamma_2 \cdot l_c$$
  avec $\gamma_1 \geq 0.5$ et $\gamma_2 = 1$, de préférence $\gamma_1 = 0.7$.

- Selon un exemple, la première électrode est située à l'intérieur du circuit fermé courbe et la deuxième électrode est située à l'extérieur du circuit fermé courbe, en projection dans un plan de base xy.
- Selon un exemple, la zone de multiplication et la zone d'absorption sont en regard l'une de l'autre selon une direction perpendiculaire à la tangente au circuit c fermé courbe et parallèle audit plan de base xy. La zone de multiplication et la zone d'absorption s'étendent selon des plans parallèles audit plan de base xy et de façon sensiblement concentrique.
- Selon un exemple les première et deuxième électrodes sont disposées de part et d'autre desdites zones d'absorption et de multiplication, au moins en projection dans ledit plan de base xy.
- Selon un exemple la première électrode et la zone de multiplication sont disposées de part et de la zone d'absorption. Ce mode de réalisation permet d'obtenir une photodiode latérale.
- Selon un exemple, la photodiode comprend en outre une zone de charge intercalée entre la zone d'absorption et la zone de multiplication.

Dans le cas d'une photodiode latérale, la couche de charge permet de réduire le bruit de multiplication sans affecter la propagation du flux lumineux, et en particulier sans induire de pertes optiques.

Dans le cas d'une photodiode à largeur de zone d'absorption fine, la couche de charge permet de limiter ou de supprimer une diminution de bande passante liée à un fonctionnement à basse tension de la photodiode.

La zone de multiplication et la zone de charge s'étendent selon des plans parallèles audit plan de base xy et de façon sensiblement concentrique.

- Selon un exemple, la zone d'absorption est au contact de la zone de multiplication.

Ce mode de réalisation permet de réduire la complexité et le coût d'obtention de la photodiode puisque la réalisation de la zone de charge, habituellement fine, est en pratique complexe à réaliser.

- Selon un exemple, la photodiode comprend en outre un guide d'entrée configuré pour former un couplage évanescent avec le guide d'onde de manière à guider le flux lumineux depuis l'extérieur dudit guide d'onde jusqu'à l'intérieur dudit guide d'onde.

Le procédé selon l'invention peut comprendre notamment les caractéristiques optionnelles ci-après pouvant être utilisées en association ou alternativement :

Selon un mode de réalisation, le procédé comprend l'étape suivante effectuée après ledit dépôt de germanium (Ge) et avant ladite lithographie de manière à définir des limites du guide d'onde selon un circuit fermé courbe comprenant la zone d'absorption :

- Dépôt de silicium (Si), de préférence par épitaxie, sur ladite couche supérieure et sur la zone d'absorption.

Selon un mode de réalisation, le procédé comprend les étapes suivantes :

- Dépôt de silicium, de préférence par épitaxie, sur la couche supérieure et sur la zone d'absorption.
- Polissage mécano-chimique successif à l'épitaxie de germanium.
- Polissage mécano-chimique successif à l'épitaxie de silicium.
- Encapsulation du cœur du guide d'onde dans une couche d'encapsulation, par exemple par dépôt de $SiO_2$.

Pour déterminer un mode de propagation et/ou une position d'un flux lumineux se propageant dans le guide d'onde courbé, et pour déterminer des pertes optiques lors de la propagation du flux lumineux au sein de ce guide par exemple, on peut procéder à une simulation. Pour cela, on pourra utiliser :

- des méthodes d'éléments finis (FEM pour l'acronyme anglais Finite Elements Method). Le logiciel Comsol par exemple permet d'utiliser une telle méthode.
- des méthodes de propagation de faisceau (BPM pour l'acronyme anglais Beam Propagation Method). Le logiciel Rsoft par exemple permet d'utiliser une telle méthode
- des méthodes de simulations optiques de type FDTD (pour l'acronyme anglais « Finite Différence Time Domain »).

Dans la suite, la photodiode présente de préférence une configuration dite SAM ou SACM. Ces configurations sont notamment basées sur une séparation des zones d'absorption, de charge (pour la configuration SACM) et de multiplication.

Une zone d'absorption est une zone configurée pour absorber en partie au moins le flux lumineux et générer des charges électriques, ladite génération de charges résultant du phénomène d'absorption. La zone d'absorption est de préférence en germanium.

Une zone de multiplication est une zone configurée pour multiplier les charges électriques générées dans la zone d'absorption. Cette multiplication peut se faire par ionisation par impact des atomes de la zone de multiplication. Cette ionisation par impact peut être déclenchée et assistée par une forte tension de polarisation au sein de ladite zone de multiplication.

Une zone de charge est une zone configurée pour écranter vis-à-vis de la zone d'absorption un champ électrique se développant dans la zone de multiplication. Cette zone de charge a pour fonction de réduire au niveau de la zone d'absorption la vitesse des charges accélérées par ledit champ électrique en direction de la zone de multiplication. En particulier, la vitesse des charges accélérées dans la zone d'absorption est limitée par la zone de charge de manière à ce que ladite vitesse reste inférieure à un seuil au-delà duquel l'ionisation se produit significativement dans la zone d'absorption.

Dans la présente invention des types de dopage seront indiqués. Ces dopages sont des exemples non limitatifs. L'invention couvre tous les modes de réalisation dans lesquels les dopages sont inversés. Ainsi, si un exemple de réalisation mentionne pour une première zone un dopage p et pour une deuxième zone un dopage n, la présente description décrit alors, implicitement au moins, l'exemple inverse dans lequel la première zone présente un dopage n et la deuxième zone un dopage p.

Les gammes de dopage associées aux différents types de dopage sont les suivantes :

- dopage p+ : $1 \times 10^{18}$ cm$^{-3}$ à $1 \times 10^{20}$ cm$^{-3}$ avec une valeur nominale de $1 \times 10^{19}$ cm$^{-3}$
- dopage n+ : $1 \times 10^{18}$ cm$^{-3}$ à $1 \times 10^{20}$ cm$^{-3}$ avec une valeur nominale de $1 \times 10^{19}$ cm$^{-3}$
- dopage p : $1 \times 10^{17}$ cm$^{-3}$ à $1 \times 10^{18}$ cm$^{-3}$ avec une valeur nominale de $5 \times 10^{17}$ cm$^{-3}$
- dopage intrinsèque : $1.10^{15}$ cm$^{-3}$ à $1.10^{17}$ cm$^{-3}$ avec une valeur nominale de $1 \times 10^{16}$ cm$^{-3}$

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents.

Dans le cadre de la présente demande de brevet, on appelle ovale une courbe plane fermée présentant un centre ou plus généralement un barycentre. L'ovale ou le circuit ovale désigne également une forme géométrique plane fermée présentant une surface non nulle.

En particulier, l'ovale s'entend de la forme la plus générale comprenant les ellipses, les cercles et les formes oblongues notamment.

Deux formes sont dites concentriques si elles sont imbriquées l'une dans l'autre dans un même plan, ou au moins en projection dans un même plan, et si elles présentent un centre ou un barycentre commun.

Dans la suite, l'invention est décrite et illustrée à travers un cas particulier de forme en anneau. La forme en anneau n'est cependant pas limitative. L'invention couvre également des modes de réalisation comprenant des formes ovales.

En particulier, la forme elliptique et la forme oblongue sont deux alternatives à la forme en anneau couvertes par l'invention. Ainsi, toutes les caractéristiques et effets techniques décrits en référence aux modes de réalisation en anneau s'appliquent également aux autres formes ovales.

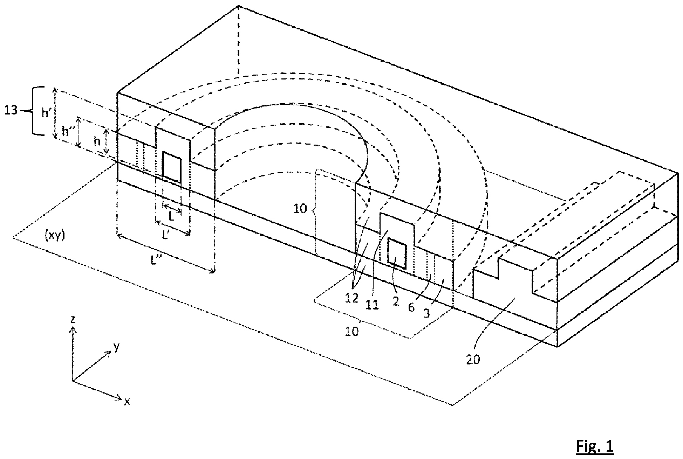

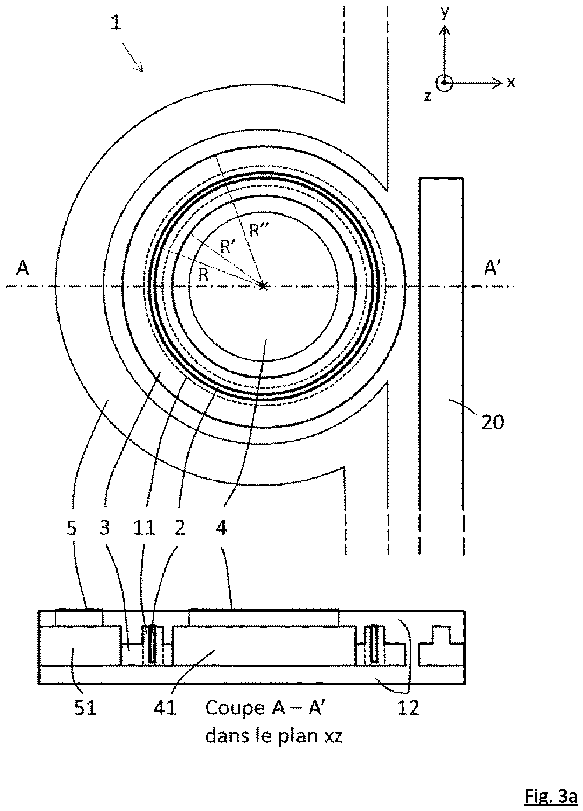

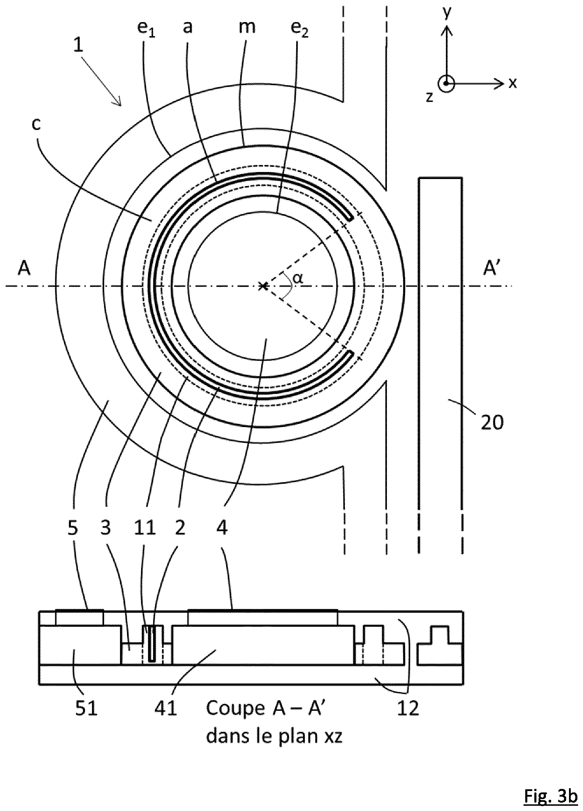

Un premier mode de réalisation d'une photodiode à avalanche selon l'invention va maintenant être décrit en référence aux figures 1, 3a et 3b.

Comme illustré en coupe transverse sur la figure 1, la photodiode comprend avantageusement un guide d'onde 10 présentant une forme ovale, et plus précisément une forme en anneau sur cette figure, sans que cette forme annulaire soit limitative.

Le guide d'onde 10 s'étend principalement dans un plan. Ce plan est parallèle au plan de base xy du repère orthogonal xyz illustré sur les figures 1 et 3a à 5.

Le guide d'onde 10 comprend un cœur 11 et une gaine 12.

La gaine 12 entoure le cœur 11 dans lequel l'essentiel du flux lumineux se propage. Typiquement, au moins 70% et de préférence au moins 80% du flux lumineux se propage à l'intérieur du cœur 11.

Le guide d'onde 10 est de préférence un guide en arête, également dénommé guide RIB.

En section dans un plan perpendiculaire à la direction principale de propagation du flux lumineux, le guide RIB peut présenter des formes variées. Sur l'exemple illustré en figure 1, le guide RIB 10 présente une forme en T inversé.

En particulier, le guide RIB 10 comprend une partie inférieure surmontée par une partie supérieure en saillie.

La partie inférieure s'étend principalement dans le plan de base xy entre deux cercles concentriques dudit plan de base xy. En particulier, la partie inférieure est comprise entre un cercle intérieur de rayon R' et un cercle extérieur de rayon R", tels que R' < R". La partie inférieure présente une hauteur h" selon l'axe z et une largeur L" selon une direction radiale telle que L" = R" - R'.

La hauteur h" peut être comprise entre 100nm et 300nm. Les rayons R' et R" peuvent être compris entre $5\mu$m et $25\mu$m, et la largeur L" peut être comprise entre 500nm et $2\mu$m.

La partie inférieure et la partie supérieure en saillie sont de préférence en silicium intrinsèque.

Le cœur 11 d'un tel guide RIB 10 s'étend verticalement depuis un flanc horizontal inférieur de la partie inférieure jusqu'à un flanc horizontal supérieur de la partie supérieure en saillie, sur toute la hauteur du T. Cette hauteur selon l'axe z est notée h'.

Le cœur 11 s'étend horizontalement entre deux surfaces verticales comprenant chacune un flanc vertical opposé de la partie supérieure en saillie.

Le cœur 11 comprend donc la partie supérieure en saillie et une portion de la partie inférieure, ladite portion étant située au droit de la partie supérieure en saillie.

Le cœur 11 présente une largeur selon une direction radiale notée L'.

La hauteur h' peut être comprise entre 200nm et 500nm. La largeur L' peut être comprise entre 150nm et 400nm.

La gaine 12 du guide d'onde 10 s'étend autour du cœur 11.

La gaine 12 peut notamment comprendre les deux portions du T situées de part et d'autre du cœur 11.

Un tel guide 10 RIB en anneau est avantageusement configuré pour confiner et pour propager un flux lumineux au niveau du cœur 11. Ce confinement peut être purement géométrique.

Le cœur 11 du guide 10 peut être avantageusement fonctionnalisé.

En particulier, il peut avantageusement comprendre une zone d'absorption 2 de la photodiode, de manière à ce que ladite zone d'absorption 2 puisse recevoir une part importante du flux lumineux se propageant dans le guide 10.

La zone d'absorption 2 est de préférence en germanium intrinsèque.

La zone d'absorption 2 s'étend principalement dans le plan de base xy. Elle forme une portion d'anneau ou un anneau complet, c'est-à-dire un anneau fermé. Le rayon de l'anneau est noté R, tel que R' < R < R".

La zone d'absorption 2 peut être de section rectangulaire. La zone d'absorption 2 présente une hauteur h selon l'axe z et une largeur L selon une direction radiale.

La hauteur h peut être comprise entre 50nm et 450nm. La largeur L peut être comprise entre 40nm et 300nm.

Le rayon R peut être compris entre 5μm et 25μm.

Dans le mode de réalisation illustré en figure 1, la zone d'absorption 2 est dite «non traversante », c'est-à-dire qu'elle est entièrement entourée par le matériau de guidage du cœur 11, c'est à dire le silicium intrinsèque dans cet exemple. En particulier, la zone d'absorption 2 peut être comprise dans la partie inférieure du T inversé de sorte que h ≈ h". Cette configuration permet aux charges électriques générées dans la zone d'absorption 2 de transiter horizontalement pour un champ électrique appliqué parallèlement au plan de base xy. L'extraction des charges est ainsi facilitée.

Selon une autre possibilité, la zone d'absorption 2 est dite « traversante » et peut traverser la partie inférieure et la partie supérieure en saillie du cœur 11, de sorte que h ≈ h'. Selon cette possibilité, la zone d'absorption 2 s'étend sur toute la hauteur du cœur 11 du guide d'onde 10 à l'exception d'une couche inférieure de silicium, située sous la zone d'absorption 2 et qui est utile à la croissance par épitaxie de la zone d'absorption 2 en germanium. Ainsi, dans ce mode de réalisation une face supérieure de la zone d'absorption 2 est non couverte par le matériau de guidage du cœur, c'est à dire le silicium intrinsèque dans cet exemple. Cette configuration permet d'augmenter le volume de germanium pour une largeur de la zone d'absorption 2 fixée.

Une partie du cœur 11 et/ou de la gaine 12, situées sur un pourtour de la zone d'absorption 2, peuvent avantageusement comprendre une zone de multiplication 3 de la photodiode. En particulier, la zone de multiplication 3 est située dans la partie inférieure du T inversé, également appelée ruban ou « slab » en anglais. De préférence, la zone de multiplication 3 est entièrement contenue dans le ruban 13. La hauteur du ruban, prise selon la direction z est h".

La zone de multiplication 3 et la zone d'absorption 2 peuvent dès lors être coplanaires dans le plan de base xy, et peuvent être avantageusement concentriques, ou présenter plus généralement un barycentre commun.

En particulier, le flanc vertical extérieur de la zone d'absorption 2 peut être en regard du flanc vertical intérieur de la zone de multiplication 3, selon une direction parallèle au plan xy, sur une majorité des hauteurs respectives desdites zones 2, 3.

La photodiode présentant une telle disposition relative des zones d'absorption et de multiplication 2, 3 est dite photodiode SAM latérale.

En particulier, la zone de multiplication 3 peut longer la zone d'absorption 2 sur un pourtour extérieur de celle-ci. Lesdites zones 2, 3 forment dès lors deux anneaux concentriques. Ces anneaux peuvent être fermés comme illustré en figure 3a ou peuvent au contraire être ouverts, c'est-à-dire partiels, comme illustré en figure 3b.

Selon une possibilité, la hauteur de la zone de multiplication 3 est égale à h" de manière à optimiser le phénomène de multiplication des porteurs. Cette configuration est illustrée en figure 1.

La zone de multiplication 3 est de préférence en silicium cristallin intrinsèque.

Une partie de la gaine 12 au niveau de la partie inférieure du T inversé (dans le ruban) peut en outre être fonctionnalisée par implantation ionique, pour créer une zone de charge 6 par exemple.

La zone de charge 6 peut être en silicium dopé p et peut former au moins une partie d'anneau intercalée entre la zone d'absorption 2 et la zone de multiplication 3. La zone de charge 6 peut présenter une largeur comprise entre 0 et 200nm et une hauteur égale à h". De préférence, la zone de charge 6 est entièrement contenue dans le ruban 13.

La zone d'absorption 2, la zone de charge 6 et la zone de multiplication 3 peuvent dès lors être coplanaires dans le plan de base xy, et peuvent être avantageusement concentriques ou présenter plus généralement un barycentre commun.

En particulier, le flanc vertical extérieur de la zone d'absorption 2 peut être en regard du flanc vertical intérieur de la zone de charge 6 selon une direction parallèle au plan xy, et le flanc vertical extérieur de la zone de charge 6 peut être en regard du flanc vertical intérieur de la zone de multiplication 3, selon une direction parallèle au plan xy, sur une majorité des hauteurs respectives desdites zones 2, 3, 6.

La photodiode présentant une telle disposition relative des zones d'absorption, de charge et de multiplication 2, 6, 3 est dite photodiode SACM latérale.

La zone de charge 6 peut permettre de réduire avantageusement le taux d'ionisation dans le germanium (où le facteur d'excès de bruit de multiplication est élevé) de la zone d'absorption 2 tout en maintenant un taux d'ionisation important dans le silicium (où le bruit de multiplication est faible) de la zone de multiplication 3.

Ceci contribue à optimiser les sources de bruit de multiplication de manière à réduire le facteur d'excès de bruit.

Cependant, le taux d'ionisation dans le germanium peut être très faible voire sensiblement nul sur une distance d (appelée également « dead space » selon la terminologie anglaise) parcourue par les électrons au sein du germanium. Cette distance d est mesurée selon une direction parallèle au plan xy et perpendiculaire à la direction principale de propagation du flux lumineux. Cette direction est radiale dans le cas d'une zone d'absorption 2 annulaire telle qu'illustrée à la figure 1. Dans le germanium, la distance d est de l'ordre de 100nm.

Dès lors, il peut être particulièrement avantageux d'avoir une zone d'absorption 2 en germanium de largeur L ≤ d. Dans cet exemple non limitatif, on aurait donc L ≤ 100nm. Dans cette configuration, la zone de charge 6 n'est plus nécessaire.

Une photodiode SAM présentant une largeur de zone d'absorption 2 en germanium L ≤ d peut donc offrir des performances semblables à une photodiode SACM en termes de facteur d'excès de bruit de multiplication, tout en étant avantageusement plus facile à réaliser.

La photodiode selon l'invention permet avantageusement de compenser une réduction de largeur de la zone d'absorption 2 en confinant la propagation du flux lumineux au sein d'un circuit fermé, tel que le guide d'onde 10 RIB en anneau, de manière à absorber la totalité dudit flux lumineux.

Ainsi, comme clairement illustré en figure 1, la photodiode est de type photodiode latérale.

En particulier, la couche d'absorption 2, la couche de multiplication 3 et la zone de charge 6 si elle est présente sont en partie au moins contenues dans des plans identiques, parallèles au plan de base xy et sont concentriques dans ces plans.

Ainsi, sur une portion au moins de leur hauteur h et h", prise selon une direction z perpendiculaire au plan de base xy, et en chaque point du circuit c fermé courbe, la zone d'absorption 2 est en regard, de préférence entièrement en regard, de la zone de multiplication 3 selon une direction parallèle au plan de base xy et perpendiculaire à la tangente au circuit c fermé courbe en ce point.

Dans l'exemple illustré en figure 1, h est inférieure à h". La zone d'absorption 2 est alors entièrement contenue dans des plans superposés contenant également une partie de la zone de multiplication 3, ces plans étant parallèles au plan de base xy. De même la zone d'absorption 2 est entièrement contenue dans des plans superposés contenant également une partie de la zone de charge 6 lorsqu'elle est présente, ces plans étant parallèles au plan de base xy.

Ainsi, la zone de multiplication 3 ou la zone de charge 6 si elle est présente n'est pas située à l'aplomb, c'est-à-dire au-dessus ou au-dessous, de la zone d'absorption selon une direction z perpendiculaire au plan de base xy.

La zone d'absorption 2 et la zone de multiplication 3, s'étendent respectivement selon une portion courbe d'un circuit a et une portion courbe d'un circuit m. La première électrode 4 et la deuxième électrode 5 s'étendent respectivement selon une portion courbe d'un circuit e1 et une portion courbe d'un circuit e2. En projection sur le plan de base xy :

◦ lesdites portions courbes desdits circuits a, m et e2 sont parallèles entre elles sur une partie au moins de leurs longueurs respectives, et

◦ la première électrode 4 est située à l'intérieur de la portion courbe du circuit a de la zone d'absorption 2,

◦ la portion courbe du circuit a de la zone d'absorption 2 est située à l'intérieur de la portion courbe du circuit m de la zone de multiplication 3,

◦ la portion courbe du circuit m de la zone de multiplication 3 est située à l'intérieur de la portion courbe du circuit e2 de la deuxième électrode 5.

Selon un exemple non limitatif, en projection sur le plan de base (xy) la zone d'absorption 2 est située à distance de la zone de multiplication 3.

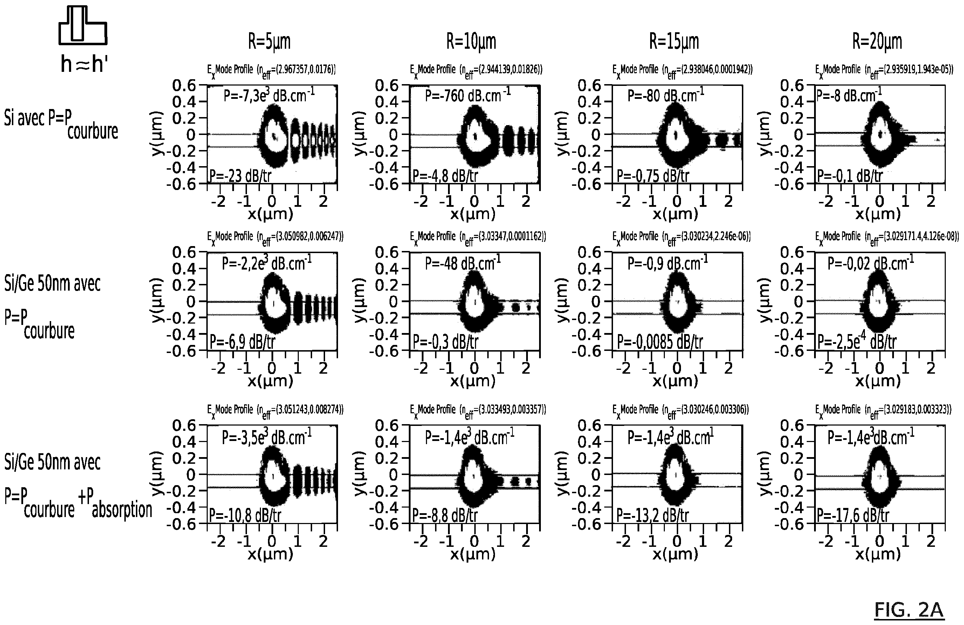

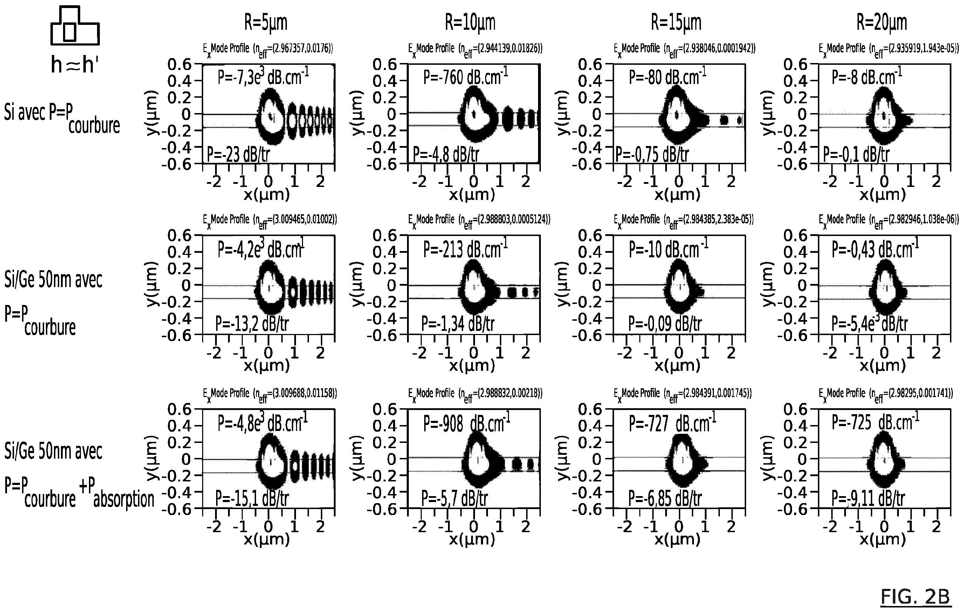

Les figures 2a et 2b illustrent la simulation du confinement d'un mode k de propagation d'un flux lumineux au sein du guide d'onde 10 RIB en anneau, pour différentes configurations dudit guide d'onde 10.

En particulier, les simulations sont réalisées pour un flux lumineux présentant une longueur d'onde $\lambda = 1,31\mu$m. Pour cette longueur d'onde, les indices de réfraction du silicium $n_{Si}$ et du germanium $n_{Ge}$ peuvent être fixés à partir d'évaluations empiriques à : $n_{Si} = 3,506$ et $n_{Ge} = 4,3 + i.0,031$.

Les simulations sont réalisées pour différents rayons de courbure R, dans cet exemple : $5\mu$m, $10\mu$m, $15\mu$m et $20\mu$m.

Les simulations sont en outre réalisées :

- pour un cœur 11 du guide d'onde 10 en silicium cristallin pur, en intégrant des pertes par courbure (sur une première ligne nommée « Si avec P = $P_{courbure}$ »),
- pour un cœur en silicium comprenant une zone d'absorption 2 en germanium de largeur L = 50nm, en intégrant les pertes par courbure (sur une deuxième ligne nommée « Si/Ge 50nm avec P = $P_{courbure}$ »), et
- pour un cœur en silicium comprenant une zone d'absorption 2 en germanium de largeur L = 50nm, en intégrant les pertes par courbure et des pertes par absorption (sur une troisième ligne nommée « Si/Ge 50nm avec P = $P_{courbure}$ + $P_{absorption}$ »).

Les pertes P (dB.cm$^{-1}$) sont calculées à partir de la partie imaginaire de l'indice effectif du mode k, selon la formule :

$$P = -\frac{40.\pi.k}{\lambda.\ln 10}$$

La figure 2a montre des simulations effectuées dans le cas où la zone d'absorption 2 est « traversante », comme défini ci-dessus, c'est à dire pour h ≈ h'.

La figure 2b montre des simulations effectuées dans le cas où la zone d'absorption 2 est « non traversante », comme défini ci-dessus, avec de préférence h ≈ h".

Il apparaît, par comparaison entre la première et la deuxième ligne pour chacune des figures, que les pertes par courbure dans un guide d'onde 10 dont le cœur 11 comprend une zone d'absorption 2 en germanium sont fortement diminuées par rapport aux pertes par courbure dans un guide d'onde 10 de même géométrie dont le cœur 11 est en silicium pur.

La présence du germanium contribue avantageusement à guider le flux lumineux au sein du cœur du guide en arête, bien que la faible largeur L = 50nm de la zone d'absorption 2 soit insuffisante pour guider le flux lumineux par contraste d'indice.

Cet effet non prévu peut permettre de dimensionner un guide d'onde 10 RIB en anneau présentant un rayon de courbure diminué.

En particulier, en configuration « traversante » pour h ≈ h' (figure 2a), le guide d'onde peut avantageusement présenter un rayon de courbure R = 10μm.

Alternativement, pour h ≈ h" (figure 2b), le guide d'onde peut avantageusement présenter un rayon de courbure R = 15μm.

Des simulations (non illustrées) réalisées pour un flux lumineux présentant une longueur d'onde A = 1,55μm et pour des indices de $n_{Si}$ = 3,47 et $n_{Ge}$ = 4,3 + i.0,0049 montrent que les pertes par absorption du germanium sont dans ce cas plus faibles, de l'ordre de 1dB/tour. En particulier, plusieurs tours au sein du guide 10 RIB en anneau peuvent être requis pour absorber la totalité du flux lumineux.

A cette longueur d'onde, les pertes par courbure augmentent.
Par conséquent, pour A = 1,55μm :

- pour h ≈ h' (en configuration « traversante »), le guide d'onde 10 peut avantageusement présenter un rayon de courbure R = 15μm.
- pour h ≈ h" (en configuration «non traversante »), le guide d'onde 10 peut avantageusement présenter un rayon de courbure R = 20μm.

Afin d'injecter le flux lumineux au sein du guide d'onde 10, un guide d'entrée 20 peut être couplé audit guide d'onde 10.

Ce couplage peut être un couplage évanescent standard, c'est-à-dire que les deux guides 10, 20 peuvent être séparés l'un de l'autre d'une distance inférieure à la longueur d'onde du flux lumineux.

Cette distance est de préférence ajustée afin d'obtenir un couplage critique, de manière à ce que la totalité du flux lumineux se propageant dans le guide d'entrée 20 soit absorbée par le guide d'onde 10.

Cette distance de couplage critique peut notamment être obtenue à l'aide de méthodes de simulations optiques de type FDTD (pour l'acronyme anglais « Finite Différence Time Domain »).

De manière générale, dans le cadre de la présente invention, la photodiode présente des paramètres dimensionnels permettant au flux lumineux à détecter d'effectuer plusieurs tours du circuit fermé défini par le guide d'onde. Ainsi, en fonction des paramètres du flux lumineux (tels que longueur d'onde et la puissance notamment), on adapte les paramètres dimensionnels suivants de la photodiode afin de permettre au flux lumineux d'effectuer plusieurs tours de circuit : forme du circuit, rayon(s) de courbure, forme du cœur, volume de germanium, distance de couplage entre le guide d'entrée et le guide d'onde.

En référence aux figures 3a et 3b, une première électrode 4 de la photodiode 1 peut s'étendre, en projection sur le plan de base xy, dans une zone intérieure du guide d'onde 10 délimitée par le cercle de rayon R'.

Cette première électrode 4 peut présenter une forme de disque ou d'anneau par exemple.

Une deuxième électrode 5 de la photodiode 1 peut s'étendre, en projection sur le plan de base xy, dans une zone extérieure du guide d'onde 10 au-delà du cercle de rayon R".

Les première et deuxième électrodes 4, 5 s'étendent de préférence dans une couche supérieure surmontant une couche de base comprenant le ruban du guide d'onde 10.

Sur une première portion angulaire du guide d'onde 10, les première 4 et deuxième 5 électrodes sont disposées de part et d'autre du guide d'onde 10, selon une direction parallèle au plan xy et perpendiculaire à la direction principale du flux lumineux dans le guide d'onde 10.

Sur une deuxième portion angulaire du guide d'onde 10, les première 4 et deuxième 5 électrodes peuvent ne pas être disposées de part et d'autre du guide d'onde 10, afin de faciliter le couplage entre le guide d'entrée 20 et le guide d'onde 10 par exemple. Comme illustré sur les figures 3a et 3b, la deuxième électrode 5 peut présenter une forme en Ω, afin de ménager un espace pour le guide d'entrée 20.

Les première et deuxième électrodes 4, 5 sont de préférence métalliques et déposées sur une première et une deuxième zone de contact 41, 51 respectivement.

Ces première et deuxième zones de contact 41, 51 peuvent être en silicium respectivement dopées p+ et n+.

La collecte des électrons se fait de préférence par la deuxième électrode 5. Les électrons peuvent transiter radialement entre la zone d'absorption 2 et la deuxième électrode 5.

La bande passante de la photodiode 1 est affectée par le temps de transit des porteurs (électrons et trous), et par un temps caractéristique de relaxation $\tau$ de la photodiode 1. Cette bande passante est proportionnelle à la fonction de transfert $H_{photo}$ de la photodiode 1.

La fonction de transfert liée au transit des porteurs s'écrit :

$$H_{tr} = \left[\frac{1}{(\omega\tau_n)^2}\left(1 - e^{j\omega\tau_n}\right) - \frac{1}{j\omega\tau_n}\right] + \left[\frac{1}{(\omega\tau_p)^2}\left(1 - e^{j\omega\tau_p}\right) - \frac{1}{j\omega\tau_p}\right]$$

Où $\tau_{n,p}$ sont respectivement les temps de transit des électrons et des trous.

Le temps caractéristique de relaxation $\tau$ permet de modéliser une partie de la photodiode 1 par un système RC avec $\tau = RC$, où R et C sont respectivement la résistance et la capacité de ladite partie de la photodiode 1.

Dès lors, la fonction de transfert lié à ce système RC s'écrit :

$$H_{RC} = \frac{1}{1 + j(R_S + R_L)C_{éq}\omega}$$

Où $R_S$ est la résistance des zones dopées et des électrodes, et $R_L$ représente une résistance de charge d'un circuit externe de mesure du courant. La capacité $C_{éq}$ vaut : $C_{éq} = \varepsilon Hl/L$, avec H = h + h' la hauteur du cœur 11 du guide 10, $l$ la longueur de la deuxième électrode 5, $\varepsilon$ la permittivité diélectrique du Ge, et L la largeur de la zone d'absorption 2.

La fonction de transfert totale de la photodiode 1 s'écrit :

$$H_{photo} = H_{tr}H_{RC}$$

Afin de maximiser $H_{photo}$ donc la bande passante de la photodiode 1, la capacité $C_{éq}$ doit être minimisée.

En particulier, la longueur $l$ de la deuxième électrode 5 peut être avantageusement réduite en conservant une absorption totale dans la zone d'absorption 2 et une collecte efficace des électrons.

Pour ce faire, la longueur $l$ de la deuxième électrode 5 est de préférence sensiblement inférieure ou égale au périmètre extérieur du guide 10 en anneau, $l \lessgtr 2k\pi R$" avec $0,95 \le k \le 1,05$.

Un flux lumineux parcourant le guide d'onde 10 sur au moins un tour d'anneau avant d'être totalement absorbé va générer une première fois des électrons lors d'un premier passage en un premier endroit de la zone d'absorption 2, puis une deuxième fois des électrons lors d'un deuxième passage audit premier endroit par exemple.

Ainsi, la collecte des électrons générés successivement lors de ces premier et deuxième passages se fait par une même portion de la deuxième électrode 5.

Une longueur $l$ de la deuxième électrode 5 peut donc permettre de collecter des électrons générés sur une distance $l_{tot}$ parcourue par le flux lumineux au sein de la zone d'absorption 2, tel que : $l < l_{tot}$.

Le guide 10 en anneau permet ainsi de propager le flux lumineux jusqu'à ce que ce dernier soit totalement absorbé par la zone d'absorption 2, tandis que la longueur d'électrode 5 nécessaire à la collecte des électrons peut être avantageusement inférieure à la distance parcourue par ledit flux lumineux.

La photodiode 1 est ainsi configurée pour absorber totalement le flux lumineux tout en minimisant la capacité $C_{éq}$ liée à la longueur de l'électrode 5. La bande passante de cette photodiode 1 peut ainsi être améliorée.

Comme indiqué précédemment, la figure 3a illustre un mode de réalisation dans lequel la zone d'absorption 2 forme un anneau complet. Le flux lumineux est donc absorbé de manière continue tout au long de son parcours dans le guide d'onde 10.

Selon une autre possibilité illustrée à la figure 3b, la zone d'absorption 2 forme une portion d'anneau en regard de la deuxième électrode 5.

En particulier, un secteur angulaire correspondant à la deuxième portion angulaire dépourvue de deuxième électrode 5 peut avantageusement être dépourvu de zone d'absorption 2. Ainsi, comme illustré sur la vue en coupe selon le plan zx de la figure 3b, une section (à droite sur la figure) du cœur 11 du guide d'onde 10 ne comprend que le matériau de guidage du flux lumineux, c'est-à-dire du silicium dans cet exemple. Une autre section (à gauche sur la figure) du cœur 11 du guide d'onde 10 comprend le matériau de guidage du flux lumineux ainsi que la zone d'absorption 2.

De cette manière, le flux lumineux se propageant dans ladite deuxième portion angulaire n'est pas absorbé afin de ne pas générer inutilement des électrons, lesdits électrons ne pouvant par ailleurs pas être collectés.

En outre, le flux n'étant pas absorbé, il peut parcourir une distance plus grande au sein du guide 10, ladite distance pouvant dépasser avantageusement un tour du guide 10 RIB en anneau.

Le secteur angulaire peut présenter un angle α compris entre 30° et 180°.

Cette configuration permet d'augmenter l'efficacité et le rendement de la photodiode 1, tout en tirant un meilleur profit des différents avantages présentés plus haut.

Avantageusement, notamment pour réduire les pertes, la photodiode comprend les électrodes 4 et 5 uniquement.

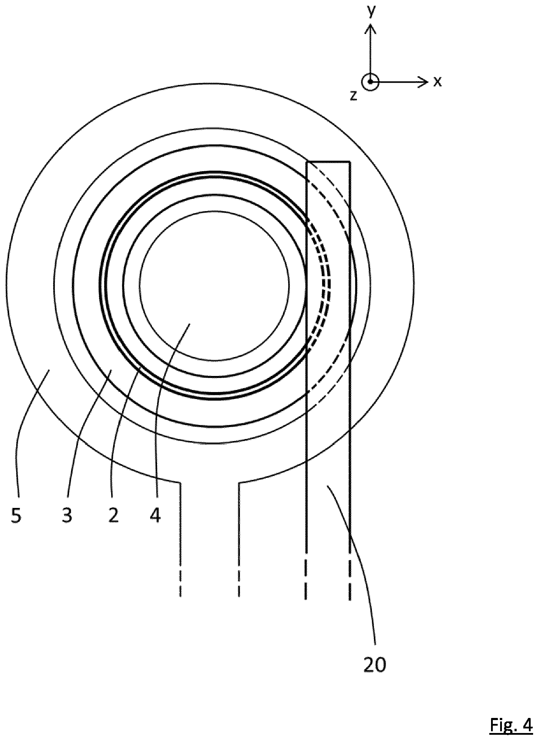

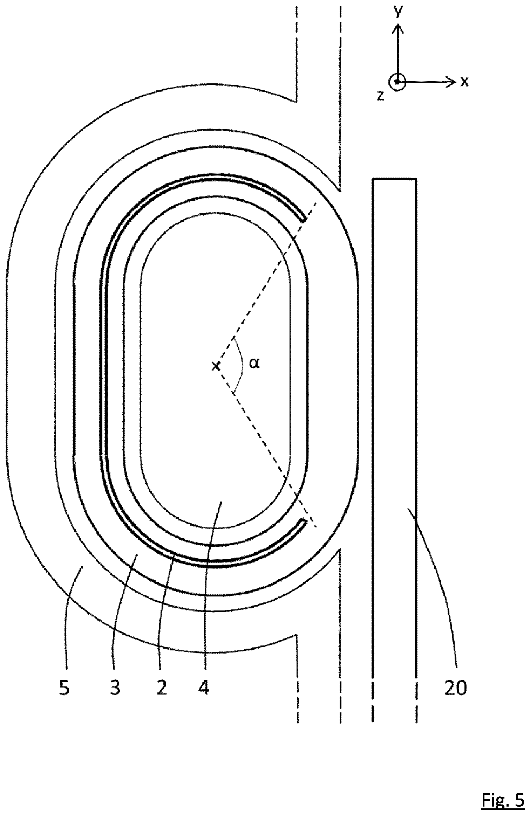

D'autres modes de réalisation d'une photodiode 1 sont illustrés aux figures 4 et 5.

Seules les caractéristiques distinctes du premier mode de réalisation sont décrites ci-après, les autres caractéristiques non décrites étant réputées identiques à celles du premier mode de réalisation.

La figure 4 illustre une photodiode 1 comprenant une deuxième électrode 5 annulaire. Cette deuxième électrode 5 annulaire forme une courbe fermée qui entoure entièrement le guide d'onde 10. Cette électrode 5 annulaire peut avantageusement permettre d'améliorer la collecte des électrons.

Dans cette configuration, la première électrode 4, le guide d'onde 10 et la deuxième électrode 5 sont concentriques.

En outre, la zone d'absorption 2 et la zone de multiplication 3 sont annulaires. La deuxième électrode 5 entoure entièrement le circuit courbe fermé formé par la zone d'absorption 2.

Le guide d'entrée 20 peut avantageusement être positionné dans un plan parallèle au plan de base xy, à une altitude selon z supérieure à l'altitude du plan de base xy. Le guide d'entrée 20 est ainsi positionné au-dessus du guide 10 en anneau.

La figure 5 illustre une photodiode 1 dont le guide d'onde 10 forme un ovale et présente au moins une première portion rectiligne combinée avec au moins une première portion curviligne ou courbée, de manière à former un circuit fermé.

Les zones d'absorption et de multiplication 2, 3, et les première et deuxième électrodes 4, 5 peuvent chacune présenter également au moins une portion rectiligne parallèle à ladite au moins une première portion rectiligne, et au moins une portion curviligne parallèle à ladite au moins une première portion curviligne.

En particulier, le guide d'onde 10 peut présenter une forme oblongue.

Le guide d'entrée 20 peut avantageusement être en partie parallèle à une portion de l'ovale, de préférence rectiligne, de manière à améliorer le couplage avec le guide d'onde 10. En effet, le couplage entre lesdits guide d'onde 10 et guide d'entrée 20 se fait ainsi sur une longueur de couplage supérieure à celle existante entre deux guides sans portions parallèles. Pour un même taux de couplage, cette longueur de couplage plus importante permet proportionnellement d'augmenter une distance d'éloignement entre les deux guides 10, 20. Une augmentation de la distance d'éloignement permet d'avoir un meilleur contrôle lors des étapes technologiques de fabrication de ces guides 10, 20. En particulier, l'imprécision relative sur la distance d'éloignement est plus faible lorsque cette distance d'éloignement augmente. Avec cette configuration, le taux de couplage peut donc être contrôlé plus précisément, en particulier de manière à atteindre le couplage critique (taux de couplage de l'ordre de 100%). Le couplage critique permet notamment de transférer la totalité du flux lumineux se propageant dans le guide d'entrée 20 dans le guide d'onde 10.

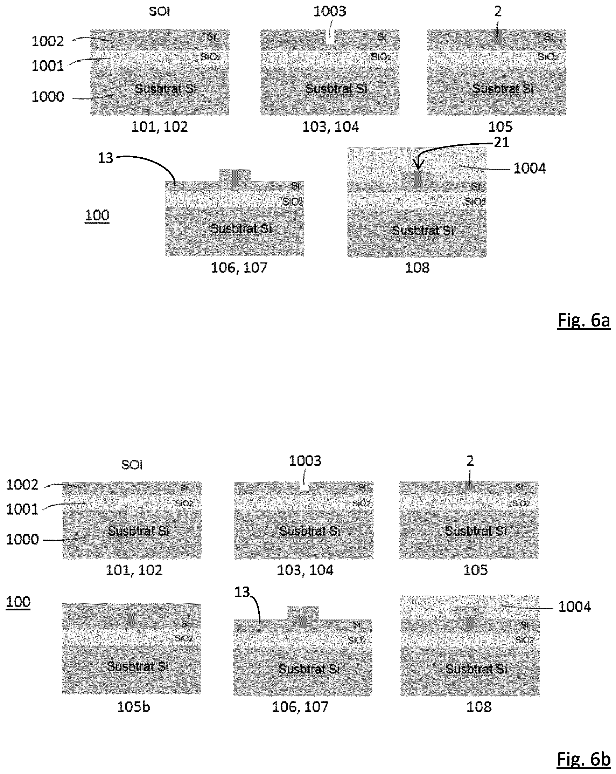

En référence aux figures 6a, 6b deux exemples de procédé de fabrication d'une photodiode selon l'invention vont maintenant être décrits.

Un premier exemple de procédé de réalisation est illustré en figure 6a. Ce procédé comprend au moins les étapes suivantes :

- Fournir 101 un empilement comprenant un substrat de support 1000 surmonté d'une couche isolante 1001, elle-même surmontée d'une couche de silicium supérieure 1002. Typiquement cet empilement constitue un substrat de type silicium sur isolant (SOI). Le substrat de support 1000 est typiquement en silicium et la couche isolante 1001 est une couche d'oxyde enterré.
- Implantation 102 ionique du substrat SOI au niveau des zones de contact 41, 51. La zone de contact 41 peut être implantée de manière à présenter un dopage p+ et la zone de contact 51 peut être implantée de manière à présenter un dopage n+.
- Lithographie 103 de manière à définir des limites de la zone d'absorption 2 dans un plan xy. La lithographie est effectuée de manière à ce que la zone d'absorption 2 forme, dans le plan xy, une courbe fermée ou ouverte.
- Gravure 104 partielle du silicium selon l'axe z de manière à former une cavité 1003. La gravure est stoppée suffisamment tôt pour conserver une épaisseur résiduelle de silicium dans le fond de la cavité 1003. En ce sens, la gravure 104 est une gravure partielle. Cette épaisseur résiduelle permet de faciliter la croissance du germanium par épitaxie lors de l'étape suivante. La gravure peut se faire par gravure sèche RIE par exemple.
- Epitaxie 105 de germanium dans ladite cavité de manière à former la zone d'absorption 2.
- Polissage mécano-chimique (CMP) parallèle au plan xy.
- Lithographie 106 de manière à définir des limites pour la partie supérieure du cœur 11 du guide d'onde 10 RIB selon un anneau comprenant la zone d'absorption 2.

14

- Gravure 107 du silicium de manière à former ladite partie supérieure du cœur 11 du guide d'onde 10. La portion inférieure de la couche de silicium définit ainsi le ruban 13
- Encapsulation 108 du cœur 11 du guide d'onde 10 par dépôt d'une couche d'encapsulation 1004 de préférence en SiO$_2$.
- Formation des première et deuxième électrodes 4, 5 au niveau des zones de contact 41, 51.

Les étapes 106 et 107 décrites ci-dessus sont avantageuses pour obtenir une configuration avec zone d'absorption 2 de type « traversante », c'est-à-dire dans laquelle la face supérieure de la zone d'absorption 2 n'est pas recouverte par du silicium, de préférence du silicium intrinsèque.

Ainsi, dans ce mode de réalisation, la zone d'absorption 2 présente une partie recouverte et de préférence au contact du silicium et une partie directement au contact de la couche d'encapsulation 1004. Ainsi la zone d'absorption 2 affleure le silicium. La partie directement au contact de la couche d'encapsulation 1004 est de préférence la partie supérieure 21 de zone d'absorption 2.

Avantageusement, dans ce mode de réalisation, la couche de multiplication 3 est intégralement située dans le ruban 13. De même la zone de charge 6, dans le cas où elle est présente, est intégralement située dans le ruban 13.

En projection sur le plan de base (xy) la zone de multiplication 3 et la première électrode 4 sont situées de part et d'autre de la zone d'absorption 2.

Le procédé de fabrication 100 peut également comprendre les étapes suivantes, qui sont avantageuses pour l'obtention d'une configuration avec zone d'absorption 2 de type «non traversante », c'est-à-dire dans laquelle la face supérieure de la zone d'absorption 2 est recouverte par du silicium (la zone d'absorption 2 présentant alors une hauteur h ≈ h") :

- dépôt d'une couche additionnelle de silicium par épitaxie 105b de silicium après l'étape d'épitaxie 105 du germanium et l'étape optionnelle de polissage, et
- Polissage mécano-chimique avant l'étape de lithographie 106.

Lors de la lithographie effectuée de manière à définir la forme du guide d'onde 10, et ainsi le ruban 13 on fait en sorte de conserver du silicium sur la face supérieure de la couche absorption 2. Cette dernière se trouve ainsi entièrement encapsulée dans du silicium. La couche absorption 2 n'affleure pas la couche de silicium du cœur. La couche absorption 2 n'est pas au contact de la couche d'encapsulation 1004 formant une partie de la gaine.

Le procédé 100 peut également comprendre une pluralité d'étapes d'implantation ionique, de manière à former la zone de charge 6 dopée p.

Avantageusement, les photodiodes réalisées selon les procédés décrits en référence aux figures 6a et 6b permettent l'obtention de photodiodes latérales. Les caractéristiques et avantages mentionnés précédemment relativement aux photodiodes latérales, notamment mentionnés en référence à la figure 1, sont naturellement applicables aux photodiodes réalisées selon les procédés décrits en référence aux figures 6a et 6b.

Ainsi, la couche d'absorption 2, la couche de multiplication 3 (et la zone de charge 6) si elle est présente sont en partie au moins contenues dans des plans identiques, parallèles au plan de base xy et sont concentriques dans ces plans.

Ainsi, sur une portion au moins de leur hauteur et en chaque point du circuit c fermé courbe, la zone d'absorption 2 est en regard, de préférence entièrement en regard, de la zone de multiplication 3 (et de la zone de charge 6 si elle est présente) la selon une direction parallèle au plan de base xy et perpendiculaire à la tangente au circuit c fermé courbe en ce point.

De même la zone de multiplication 3 ou la zone de charge 6 si elle est présente n'est pas située à l'aplomb, c'est-à-dire au-dessus ou au-dessous, de la zone d'absorption selon une direction z perpendiculaire au plan de base xy.

Au vu de la description qui précède, il apparaît clairement que l'invention propose une solution particulièrement efficace pour obtenir une photodiode à avalanche présentant une compacité et une bande passante améliorées tout en limitant le facteur d'excès de bruit.

L'invention n'est pas limitée aux modes de réalisations précédemment décrits et s'étend à tous les modes de réalisation couverts par les revendications.

**Revendications**

1. Photodiode à avalanche (1) comprenant une zone d'absorption (2), une zone de multiplication (3), une première électrode (4) et une deuxième électrode (5), **caractérisée en ce que** :

    - la photodiode (1) comprend en outre un guide d'onde (10) formant, en projection selon un plan de base (xy), un circuit c fermé courbe, apte à guider un flux lumineux sur plusieurs tours dudit circuit c,
- la zone d'absorption (2) s'étend sur une portion au moins dudit circuit c fermé courbe, et
- la zone de multiplication (3), les première (4) et deuxième (5) électrodes s'étendent le long d'une partie au moins dudit circuit c fermé courbe, **caractérisé en ce que** la photodiode forme une photodiode à avalanche de type latérale, dans laquelle la zone de multiplication (3) et la zone d'absorption (2) sont, en chaque point du circuit fermé courbe où elles s'étendent, en regard l'une de l'autre selon une direction parallèle au plan de base (xy) et perpendiculaire à la tangente au circuit c fermé courbe, dans laquelle la zone de multiplication (3) et la zone d'absorption (2) s'étendent, en projection sur le plan de base (xy) de façon concentrique, et dans laquelle, au moins en projection dans ledit plan de base (xy) :

◦ les première (4) et deuxième (5) électrodes sont disposées de part et d'autre desdites zones d'absorption (2) et de multiplication (3), et
◦ la première (4) électrode et la zone de multiplication (3) sont disposées de part et d'autre de la zone d'absorption (2).

2. Photodiode selon la revendication précédente dans laquelle la zone d'absorption (2), la zone de multiplication (3), la deuxième électrode (5) s'étendent respectivement selon une portion courbe d'un circuit a, une portion courbe d'un circuit m, et une portion courbe d'un circuit e2, lesdites portions courbes desdits circuits a, m et e2 étant, en projection sur le plan de base (xy), parallèles entre elles sur une partie au moins de leurs longueurs respectives et dans laquelle en projection sur le plan de base (xy):

◦ la première électrode (4) est située à l'intérieur de la portion courbe du circuit a de la zone d'absorption (2),
◦ la portion courbe du circuit a de la zone d'absorption (2) est située à l'intérieur de la portion courbe du circuit m de la zone de multiplication (3),
◦ la portion courbe du circuit m de la zone de multiplication (3) est située à l'intérieur de la portion courbe du circuit e2 de la deuxième électrode (5).

3. Photodiode selon l'une quelconque des revendications précédentes dans laquelle la zone d'absorption (2) forme au moins une portion d'un premier circuit ovale et la zone de multiplication (3) forme au moins une portion d'un deuxième circuit ovale, de sorte que les barycentres desdits premier et deuxième circuits ovales soient confondus.

4. Photodiode selon l'une quelconque des revendications précédentes dans laquelle le guide d'onde (10) comprend un cœur (11) et une gaine (12) et dans laquelle la zone d'absorption (2) est située au moins en partie au niveau dudit cœur (11).

5. Photodiode selon la revendication précédente, dans laquelle le cœur (11) comprend un matériau de guidage, de préférence du silicium, de préférence du silicium intrinsèque, différent d'un matériau de la zone d'absorption (2) et dans laquelle le matériau de guidage enveloppe entièrement la zone d'absorption (2).

6. Photodiode selon la revendication précédente dans laquelle la zone d'absorption (2) présente une hauteur h sensiblement égale à une hauteur h' de la zone de multiplication (3), dans laquelle la zone d'absorption (2) et la zone de multiplication (3) sont en regard l'une de l'autre selon une direction parallèle au plan de base (xy) et perpendiculaire à la tangente au circuit c fermé courbe, et dans laquelle la zone d'absorption (2) et la zone de multiplication (3) sont contenues entre des plans parallèles entre eux et parallèles audit plan de base (xy) et les hauteurs h et h', étant mesurées selon une direction qui est perpendiculaire audit plan de base (xy).

7. Photodiode selon la revendication 4, dans laquelle le cœur (11) comprend un matériau de guidage, de préférence du silicium intrinsèque, différent d'un matériau de la zone d'absorption (2) et dans laquelle le matériau de guidage enveloppe une partie seulement de la zone d'absorption (2), et la gaine (12) enveloppe une partie complémentaire de la zone d'absorption (2) en étant au contact de ladite partie complémentaire de la zone d'absorption (2).

8. Photodiode selon l'une quelconque des revendications précédentes dans laquelle la zone d'absorption (2) forme un circuit courbe fermé, et dans laquelle la première (4) et la deuxième (5) électrode sont situées de part et d'autre de la zone d'absorption (2), la deuxième électrode (5) entourant entièrement ledit circuit courbe fermé formé par la zone d'absorption (2).

9. Photodiode selon l'une quelconque des revendications 1 à 7 dans laquelle la zone d'absorption (2) forme un circuit courbe ouvert de sorte que le guide d'onde (10) présente une portion exempte de zone d'absorption (2), et dans laquelle la première et la deuxième électrode ne sont pas situées de part et d'autre de ladite portion du guide d'onde (10) exempte de zone d'absorption (2).

10. Photodiode selon l'une quelconque des revendications précédentes dans laquelle la zone d'absorption (2) présente une largeur L < 200nm, de préférence L < 100nm, et la largeur L, en un point donné, étant mesurée selon une direction qui est parallèle audit plan de base (xy) et qui est perpendiculaire à une tangente, en ce point donné, à la zone d'absorption (2).

11. Photodiode selon l'une quelconque des revendications précédentes dans laquelle la zone d'absorption (2), en projection sur le plan de base (xy), forme un premier circuit courbe présentant une longueur $l_1$, et le circuit c fermé courbe présente une longueur $l_c$, les longueurs $l_1$ et $l_c$ étant mesurées dans le plan de base (xy), tel que :
$0.5 . l_c \leq l_1 \leq 1 . l_c$ de préférence
$0.7 . l_c \leq l_1 \leq 1 . l_c$

12. Photodiode selon l'une quelconque des revendications précédentes comprenant en outre une zone de charge (6) intercalée entre la zone d'absorption (2) et la zone de multiplication (3).

13. Photodiode selon l'une quelconque des revendications précédentes comprenant en outre un guide d'entrée (20) configuré pour former un couplage évanescent avec le guide d'onde (10) de manière à guider le flux lumineux depuis l'extérieur dudit guide d'onde (10) jusqu'à l'intérieur dudit guide d'onde (10).

14. Procédé de réalisation (100) d'une photodiode selon l'une quelconque des revendications précédentes, le procédé comprenant les étapes suivantes :

- Fournir (101) un substrat de type silicium sur isolant (SOI) comprenant une couche supérieure (1002) en silicium (Si),
- Lithographie (103) de manière à définir des limites de la zone d'absorption (2) dans un plan (xy),
- Gravure (104) selon un axe (z) d'une partie seulement de l'épaisseur de la couche supérieure (1002) de manière à former une cavité (1003) délimitée par les limites de la zone d'absorption (2) définies par lithographie (103),
- Dépôt (105) de germanium (Ge), de préférence par épitaxie, dans ladite cavité (1003) de manière à former la zone d'absorption (2),
- Lithographie (106) de manière à définir des limites du guide d'onde (10) selon un circuit fermé courbe comprenant la zone d'absorption (2),
- Gravure (107) selon un axe (z) d'une partie de l'épaisseur du silicium entourant lesdites limites du guide d'onde (10), de manière à former au moins une partie du guide d'onde (10), de préférence de manière à former au moins une partie d'un guide de type guide en arête,
- Formation des électrodes au niveau de zones de contact situées de part et d'autre du guide d'onde (10).

**Patentansprüche**

1. Avalanche-Fotodiode (1), umfassend einen Absorptionsbereich (2), einen Multiplikationsbereich (3), eine erste Elektrode (4) und eine zweite Elektrode (5), **dadurch gekennzeichnet, dass**:

- die Fotodiode (1) außerdem einen Wellenleiter (10) umfasst, der, in Projektion gemäß einer Basisebene (xy), einen gekrümmten geschlossenen Kreislauf c bildet, der ausgelegt ist, um einen Lichtstrom auf mehreren Umläufen des Kreislaufs c zu leiten,
- sich der Absorptionsbereich (2) auf mindestens einem Abschnitt des gekrümmten geschlossenen Kreislaufs c erstreckt, und
- der Multiplikationsbereich (3), die erste (4) und die zweite (5) Elektrode sich entlang mindestens eines Teils des gekrümmten geschlossenen Kreislaufs c erstrecken, **dadurch gekennzeichnet, dass** die Fotodiode eine Avalanche-Fotodiode vom lateralen Typ bildet, wobei der Multiplikationsbereich (3) und der Absorptionsbereich (2) an jedem Punkt des gekrümmten geschlossenen Kreislaufs, wo sie sich erstrecken, einander gemäß einer Richtung parallel zur Basisebene (xy) und senkrecht zur Tangente zum gekrümmten geschlossenen Kreislauf c gegenüber liegen, wobei sich der Multiplikationsbereich (3) und der Absorptionsbereich (2) in Projektion auf die Basisebene (xy) auf konzentrische Weise erstrecken, und wobei, mindestens in Projektion auf der Basisebene (xy):

○ die erste (4) und zweite (5) Elektrode auf beiden Seiten des Absorptions- (2) und Multiplikationsbereichs (3) angeordnet sind,
○ die erste (4) Elektrode und der Multiplikationsbereich (3) auf beiden Seiten des Absorptionsbereichs (2) angeordnet sind.

2. Fotodiode nach dem vorhergehenden Anspruch, wobei der Absorptionsbereich (2), der Multiplikationsbereich (3), die zweite Elektrode (5) sich jeweils gemäß einem gekrümmten Abschnitt eines Kreislaufs a, eines gekrümmten Abschnitts eines Kreislaufs m und eines gekrümmten Abschnitts eines Kreislaufs e2 erstrecken, wobei die gekrümmten Abschnitte der Kreisläufe a, m und e2 in Projektion auf die Basisebene (xy) parallel zueinander auf mindestens einem Teil ihrer entsprechenden Länge sind, und wobei, in Projektion auf der Basisebene (xy):

o sich die erste Elektrode (4) im Inneren des gekrümmten Abschnitts des Kreislaufs a des Absorptionsbereichs (2) befindet,
○ sich der gekrümmte Abschnitt des Kreislaufs a des Absorptionsbereichs (2) im Inneren des gekrümmten Abschnitts des Kreislaufs m des Multiplikationsbereichs (3) befindet,
○ sich der gekrümmte Abschnitt des Kreislaufs m des Multiplikationsbereichs (3) im Inneren des gekrümmten Abschnitts des Kreislaufs e2 der zweiten Elektrode (5) befindet.

3. Fotodiode nach einem der vorhergehenden Ansprüche, wobei der Absorptionsbereich (2) mindestens einen Abschnitt eines ersten ovalen Kreislaufs bildet und der Multiplikationsbereich (3) mindestens einen Abschnitt eines zweiten ovalen Kreislaufs bildet, so dass die Baryzentren des ersten und zweiten ovalen Kreislaufs überlagert sind.

4. Fotodiode nach einem der vorhergehenden Ansprüche, wobei der Wellenleiter (10) einen Kern (11) und eine Hülle (12) umfasst, und wobei sich der Absorptionsbereich (2) mindestens teilweise auf der Ebene des Kerns (11) befindet.

5. Fotodiode nach dem vorhergehenden Anspruch, wobei der Kern (11) ein Leitmaterial umfasst, vorzugsweise Silicium, vorzugsweise intrinsisches Silicium, das verschieden von einem Material des Absorptionsbereichs (2) ist, und wobei das Leitmaterial den Absorptionsbereich (2) vollständig umhüllt.

6. Fotodiode nach dem vorhergehenden Anspruch, wobei der Absorptionsbereich (2) eine Höhe h aufweist, die im Wesentlichen gleich einer Höhe h' des Multiplikationsbereichs (3) ist, wobei der Absorptionsbereich (2) und der Multiplikationsbereich (3) einander gemäß einer Richtung gegenüber liegen, die parallel zur Basisebene (xy) und senkrecht zur Tangente zum gekrümmten geschlossenen Kreislauf c ist, und wobei der Absorptionsbereich (2) und der Multiplikationsbereich (3) zwischen untereinander parallelen und zur Basisebene (xy) parallelen Ebenen enthalten sind und die Höhen h und h' gemäß einer Richtung gemessen sind, die senkrecht zu der Basisebene (xy) ist.

7. Fotodiode nach Anspruch 4, wobei der Kern (11) ein Leitmaterial umfasst, vorzugsweise intrinsisches Silicium, das verschieden von einem Material des Absorptionsbereichs (2) ist, und wobei das Leitmaterial nur einen Teil des Absorptionsbereichs (2) umhüllt und die Hülle (12) einen komplementären Teil der Absorptionsbereichs (2) umhüllt, indem sie in Kontakt mit dem komplementären Teil des Absorptionsbereichs (2) ist.

8. Fotodiode nach einem der vorhergehenden Ansprüche, wobei der Absorptionsbereich (2) einen geschlossenen gekrümmten Kreislauf bildet, und wobei sich die erste (4) und die zweite (5) Elektrode auf beiden Seiten des Absorptionsbereichs (2) befinden, wobei die zweite Elektrode (5) vollständig den geschlossenen gekrümmten Kreislauf umgibt, der vom Absorptionsbereich (2) gebildet ist.

9. Fotodiode nach einem der Ansprüche 1 bis 7, wobei der Absorptionsbereich (2) einen offenen gekrümmten Kreislauf bildet, so dass der Wellenleiter (10) einen Abschnitt frei vom Absorptionsbereich (2) darstellt, und wobei sich die erste und die zweite Elektrode nicht auf beiden Seiten der Abschnitts des Wellenleiters (10) frei vom Absorptionsbereich (2) befinden.

10. Fotodiode nach einem der vorhergehenden Ansprüche, wobei der Absorptionsbereich (2) eine Breite L < 200 nm, vorzugsweise L < 100 nm aufweist, und wobei die Breite L an einem gegebenen Punkt gemäß einer Richtung gemessen wird, die parallel zur Basisebene (xy) ist, und die senkrecht zu einer Tangente an diesem bestimmten Punkt zum Absorptionsbereich (2) ist.

11. Fotodiode nach einem der vorhergehenden Ansprüche, wobei der Absorptionsbereich (2), in Projektion auf die Basisebene (xy), einen ersten gekrümmten Kreislauf bildet, der eine Länge $l_1$ aufweist, und der gekrümmte geschlossene Kreislauf c weist eine Länge $l_c$ auf, wobei die Längen $l_1$ und $l_c$ auf der Basisebene (xy) gemessen werden, so dass:

$0.5. 1_c \leq l_1 \leq 1. l_c$

vorzugsweise

$0.7. 1_c \leq l_1 \leq 1. l_c$

12. Fotodiode nach einem der vorhergehenden Ansprüche, außerdem umfassend, einen Änderungsbereich (6), der zwischen den Absorptionsbereich (2) und den Multiplikationsbereich (3) eingeschoben ist.

13. Fotodiode nach einem der vorhergehenden Ansprüche, umfassend außerdem einen Eingangsleiter (20), der konfiguriert ist, um mit dem Wellenleiter (10) eine flüchtige Kupplung zu bilden, um den Lichtstrom vom Äußeren des Wellenleiters (10) bis zum Inneren des Wellenleiters (10) zu leiten.

14. Verfahren zum Durchführen (100) einer Fotodiode nach einem der vorhergehenden Ansprüche, wobei das Verfahren die folgenden Schritte umfasst:

- Liefern (101) eines Substrats vom Typ Silicium-auf-Isolator (SOI), umfassend eine obere Schicht (1002) aus Silicium (Si),
- Lithographieren (103), um die Grenzen des Absorptionsbereichs (2) auf einer Ebene (xy) zu definieren,
- Gravieren (104), gemäß einer Achse (z) nur eines Teils der Dicke der oberen Schicht (1002), um einen Hohlraum (1003) zu bilden, begrenzt von den Grenzen des Absorptionsbereichs (2), die durch Lithopraphie (103) definiert werden,
- Ablagern (105) von Germanium (Ge), vorzugsweise durch Epitaxie, in dem Hohlraum (1003), um den Absorptionsbereich (2) zu bilden,
- Lithographieren (106), um die Grenzen des Wellenleiters (10) gemäß einem gekrümmten geschlossenen Kreislauf, umfassend den Absorptionsbereich (2), zu definieren,
- Gravieren (107), gemäß einer Achse (z) eines Teils der Dicke des Siliciums, der die Grenzen des Wellenleiters (10) umgibt, um mindestens einen Teil des Wellenleiters (10) zu bilden, vorzugsweise, um mindestens einen Teil einen Leiter vom Typ Kantenleiter zu bilden,
- Bilden der Elektroden auf dem Niveau von Kontaktbereichen, die sich auf beiden Seiten des Wellenleiters (10) befinden.

**Claims**

1. Avalanche photodiode (1) comprising an absorption region (2), a multiplication region (3), a first electrode (4) and a second electrode (5), **characterised in that**:

- the photodiode (1) further comprises a waveguide (10) forming, when projected on a base plane (xy), a curved closed circuit c, capable of guiding a luminous flux over a plurality of turns of said circuit c,
- the absorption region (2) extends over at least a portion of said curved closed circuit c, and
- the multiplication region (3), the first electrode (4) and the second electrode (5) extend along at least a part of said curved closed circuit c,
**characterised in that** the photodiode forms a lateral-type avalanche photodiode, wherein the multiplication region (3) and the absorption region (2) are, at each point of the curved closed circuit where they extend, facing one another in a direction parallel to the base plane (xy) and perpendicular to the tangent to the curved closed circuit c, wherein the multiplication region (3) and the absorption region (2) extend concentrically when projected on the base plane (xy), and wherein, at least when projected in said base plane (xy):

∘ the first electrode (4) and the second electrode (5) are disposed on either side of said absorption region (2) and multiplication region (3), and
∘ the first electrode (4) and the multiplication region (3) are disposed on either side of the absorption region (2).

2. Photodiode according to the preceding claim, wherein the absorption region (2), the multiplication region (3), and the second electrode (5) extend respectively along a curved portion of a circuit a, a curved portion of a circuit m, and a curved portion of a circuit e2, said curved portions of said circuits a, m and e2 being, when projected on the base plane (xy), parallel to one another over at least a part of the respective lengths thereof, and wherein, when projected on the base plane (xy):

◦ the first electrode (4) is situated inside the curved portion of the circuit a of the absorption region (2),

◦ the curved portion of the circuit a of the absorption region (2) is situated inside the curved portion of the circuit m of the multiplication region (3),

◦ the curved portion of the circuit m of the multiplication region (3) is situated inside the curved portion of the circuit e2 of the second electrode (5).

3.  Photodiode according to any one of the preceding claims, wherein the absorption region (2) forms at least one portion of a first oval circuit and the multiplication region (3) forms at least one portion of a second oval circuit, such that the barycentres of said first and second oval circuits are aligned.

4.  Photodiode according to any one of the preceding claims, wherein the waveguide (10) comprises a core (11) and a sleeve (12) and wherein the absorption region (2) is situated at least partially at said core (11).

5.  Photodiode according to the preceding claim, wherein the core (11) comprises a guide material, preferably silicon, preferably intrinsic silicon, that is different from a material of the absorption region (2) and wherein the guide material fully encases the absorption region (2).

6.  Photodiode according to the preceding claim, wherein the absorption region (2) has a height h substantially equal to a height h' of the multiplication region (3), wherein the absorption region (2) and the multiplication region (3) are facing one another in a direction parallel to the base plane (xy) and perpendicular to the tangent to the curved closed circuit c, and wherein the absorption region (2) and the multiplication region (3) are contained between planes parallel to one another and parallel to said base plane (xy) and the heights h and h', being measured in a direction which is perpendicular to said base plane (xy).

7.  Photodiode according to claim 4, wherein the core (11) comprises a guide material, preferably intrinsic silicon, that is different from a material of the absorption region (2), and wherein the guide material encases only a part of the absorption region (2), and the sleeve (12) encases a complementary part of the absorption region (2) while being in contact with said complementary part of the absorption region (2).

8.  Photodiode according to any one of the preceding claims, wherein the absorption region (2) forms a curved closed circuit, and wherein the first electrode (4) and the second electrode (5) are situated on either side of the absorption region (2), the second electrode (5) fully surrounding said curved closed circuit formed by the absorption region (2).

9.  Photodiode according to any one of claims 1 to 7, wherein the absorption region (2) forms a curved open circuit such that the waveguide (10) has a portion free from any absorption region (2), and wherein the first and the second electrodes are not situated on either side of said portion of the waveguide (10) that is free from any absorption region (2).

10. Photodiode according to any one of the preceding claims, wherein the absorption region (2) has a width L < 200 nm, preferably L < 100 nm, and the width L, at a given point, being measured in a direction which is parallel to said base plane (xy) and which is perpendicular to a tangent, at this given point, to the absorption region (2).

11. Photodiode according to any one of the preceding claims, wherein the absorption region (2), when projected on the base plane (xy), forms a first curved circuit having a length $l_1$, and the curved closed circuit c has a length $l_c$, the lengths $l_1$ and $l_c$ being measured in the base plane (xy), such that:

    $0.5 . l_c \leq l_1 \leq 1 . l_c$
    preferably
    $0.7 . l_c \leq l_1 \leq 1 . l_c$

12. Photodiode according to any one of the preceding claims, further comprising a charge region (6) inserted between the absorption region (2) and the multiplication region (3).

13. Photodiode according to any one of the preceding claims, further comprising an input guide (20) configured to form an evanescent coupling with the waveguide (10) so as to guide the luminous flux from the exterior of said waveguide (10) to the interior of said waveguide (10).

14. Method (100) for producing a photodiode according to any one of the preceding claims, the method comprising the following steps of:

- Providing (101) a silicon-on-insulator (SOI) type substrate comprising an upper layer (1002) made of silicon (Si),
- Performing lithography (103) so as to define limits of the absorption region (2) in a plane (xy),
- Etching (104), along an axis (z), only a part of the thickness of the upper layer (1002), so as to form a cavity (1003) delimited by the limits of the absorption region (2) defined by the lithography step (103),
- Depositing (105) germanium (Ge), preferably by epitaxy, in said cavity (1003) so as to form the absorption region (2),
- Performing lithography (106) so as to define limits of the waveguide (10) according to a curved closed circuit comprising the absorption region (2),
- Etching (107), along an axis (z), a part of the thickness of the silicon surrounding said limits of the waveguide (10), so as to form at least one part of the waveguide (10), preferably so as to form at least one part of a waveguide of the ridge waveguide type,
- Forming electrodes at contact regions situated on either side of the waveguide (10).

Fig. 1

FIG. 2A

FIG. 2B

1

R''
R'
R

A — A'

5 3 11 2 4

51 41 Coupe A – A'
dans le plan xz 12

20

Fig. 3a

Coupe A – A'
dans le plan xz

Fig. 3b

Fig. 4

Fig. 5

Fig. 6a

Fig. 6b

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20150108327 A
- US 20150076641 A